# EUROPEAN PATENT APPLICATION

(11) **EP 4 822 985 A1**
(43) Date of publication of application: **14.10.2026**
(21) Application number: 25305521.4
(22) Date of filing: 11.04.2025
(51) Int. Cl.: H03F 1/02, H03F 1/56, H03F 3/195, H03F 3/24

(54) **COMPACT WIDEBAND DOHERTY POWER AMPLIFIER WITHOUT AN OUTPUT TRANSFORMER**

(71) Applicant: NXP USA, Inc., Austin TX 78735 (US)
(72) Inventor: Holin, Raphael, 31023 Toulouse (FR); Lamy, Anthony, 31023 Toulouse (FR); Hue, Xavier, 31023 Toulouse (FR); Wu, Yu-Ting David, 31023 Toulouse (FR)
(74) Representative: Schwarzweller, Thomas

(57) **Abstract**

A Doherty power amplifier circuit includes a first impedance circuit (230), a second impedance circuit (260), and a third impedance circuit (276). The first impedance circuit is coupled between a carrier amplifier and a combining node (246) that is connected to an output terminal (206). The second impedance circuit (260) includes an input coupled to an output of a peaking amplifier and includes an output. The third impedance circuit (276) is coupled between the output of the second impedance circuit (260)and the combining node (246). The first impedance circuit (230) provides a first impedance and the second and third impedance circuits (260, 276) provide a second impedance to the combining node (246) to produce an output impedance configured to match a load impedance. The first impedance circuit (230) provides a ninety-degree phase offset and the second and third impedance circuits (260, 276) provide a zero-degree phase offset.

## Description

### FIELD OF USE

The present disclosure generally relates to wideband Doherty power amplifiers, and more particularly to a compact wideband Doherty power amplifier without an output transformer.

### BACKGROUND

Wireless communications systems utilize power amplifiers for increasing the power of radio frequency (RF) signals. The power amplifier circuit may form a portion of a last amplification stage in a transmission path before transmission of the RF signal via an antenna. Preferably, such power amplifiers exhibit high gain, high linearity, and stability over a range of frequencies.

Power amplifiers may operate at maximum power efficiency when the power amplifier transmits close to saturated power, and power efficiency may worsen as the power output decreases. Doherty power amplifier architectures have been adopted for base stations and mobile terminals because of the architecture's high-power efficiency over a wide power dynamic range.

Conventional Doherty power amplifier architectures may present challenges to efforts toward reducing semiconductor package sizes. For massive multi-input multi-output (mMIMO) architectures used in fifth generation (5G) antenna systems, stringent circuit footprint requirements for have led to design trade-offs for Doherty power amplifier architectures.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.
FIG. 1A depicts a block diagram of a conventional Doherty power amplifier.
FIG. 1B depicts a diagram of a circuit topology of a ninety/zero (90°/0°) Doherty power amplifier including a quasi-line and an output transformer.
FIG. 2 depicts a diagram of an embodiment of a Doherty power amplifier including three impedance sections to enable an output impedance match without an output transformer, in accordance with certain embodiments.
FIG. 3A depicts a diagram of a circuit layout including the Doherty power amplifier of FIG. 3, in accordance with certain embodiments.
FIG. 3B depicts a diagram of a circuit topology of a ninety/one hundred eighty (90°/180°) Doherty power amplifier with a reduced footprint, in accordance with certain embodiments.
FIG. 4 depicts a flow diagram of a method of designing a Doherty power amplifier having a compact topology, in accordance with certain embodiments.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the spirit and scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

### DETAILED DESCRIPTION

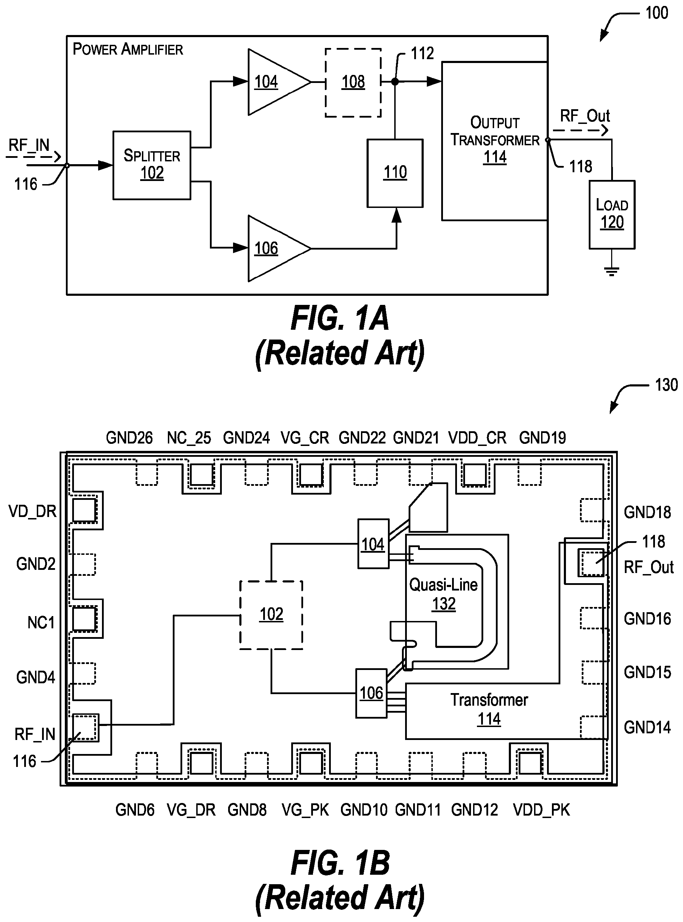

Embodiments described herein are directed to radio frequency (RF) signal amplifier devices. For example, the embodiments described herein may be implemented in two-way Doherty amplifier modules. The small footprint (small circuit area) Doherty power amplifier that provides a ninety degree/zero degree (90°/0°) configuration generally includes a quasi-line and an output transformer, as shown in FIGs. 1A and 1B, and this topology has been widely adopted in module applications due to its compact footprint.

FIG. 1A depicts a diagram of a Doherty amplifier 100 (also referred to as a two-way Doherty amplifier 100), in accordance with an example embodiment. In a two-way Doherty power amplifier 100, for example, an input signal RF_IN (e.g., a radio frequency (RF) input signal) may be received at an input node 116, which may be coupled to an input of a power splitter 102. The power splitter 102 may divide the RF input signal into two RF signals with equal or unequal power. The power splitter 102 or other circuitry at one or more of the outputs of the power splitter 102 may apply a phase shift to one or both of the two RF signals to achieve about a 90-degree phase difference between the two RF signals. The power splitter 102 may provide a first of the two RF signals to the carrier amplifier 104 and a second of the two RF signals to the peaking amplifier 106. The first and second RF signals may be separately amplified by the carrier amplifier 104 and the peaking amplifier 106 of the Doherty amplifier 100 and combined at an output stage, which may include a combining node 112 coupled to an output transformer 114, which provides an RF output signal (RF_Out) to an output node 118. The output node 118 may be coupled to a load 120, such as an antenna or another load.

In one or more embodiments, a transmission line 108 having a selected wavelength may be coupled between the output of the carrier amplifier 104 and the combining node 112 to provide a first selected phase delay. In some implementations, such as in a 90°/0° Doherty power amplifier configuration, the transmission line 108 may be omitted. In one or more embodiments, one or more transmission lines 110 may be coupled between the output of the peaking amplifier 106 and the combining node 112 to provide a second selected phase delay.

When the RF input signal (RF_IN) power level at the input node 116 is relatively low, only the carrier amplifier 104 actively amplifies its received RF signal to produce an amplified RF signal, which is provided to the load 120 via the combining node 112 and the output transformer 114. At a given RF input signal power threshold, the peaking amplifier 106 may begin amplifying its received RF signal, and the carrier amplifier 104 and the peaking amplifier 106 both output amplified RF signals that are combined, in phase, at the combining node 112 and provided to the load 120 via the output transformer 114. As the RF input signal power level at the input node 116 continues to increase, the output signal level of the peaking amplifier 106 also increases until the output signal level at the output node 118 reaches a full-power output condition. Operation of the Doherty amplifier 100 at power levels below the full-power output condition is referred to as "back-off operation."

In some Doherty amplifiers, such as a ninety degree/one hundred eight-degree (90°/180°) Doherty amplifier, a quarter wavelength transmission line 108 may be coupled between the output of the carrier amplifier 104 the combining node 112, and the one or more transmission lines 110 may include two quarter-wavelength (λ/4) transmission lines coupled in series between the output of the peaking amplifier 106 and the combining node 112. Each quarter wavelength (λ/4) transmission line may operate as a phase offset line. Accordingly, each quarter wavelength (λ/4) transmission line may apply a phase shift (e.g., an approximately 90-degree phase shift) to the amplified RF signals output from the carrier amplifier 104 and the peaking amplifier 106. The quarter wavelength transmission line(s) may compensate for the previously discussed 90-degree phase difference between the RF input signals at the inputs of the carrier amplifier 104 and the peaking amplifier 106 and may ensure that the separately amplified RF signals provided from the carrier amplifier 104 and peaking amplifier 106 arrive in phase at the combining node 112. In some architectures, the quarter wavelength (λ/4) transmission line(s) 108 and 110 may also be used to maximize the impedance seen from the carrier amplifier 104 looking into the combining node 112 to prevent a reduction in efficiency and/or linearity of the Doherty amplifier 100. For example, the characteristic impedance of the quarter wavelength (λ/4) transmission lines 108 and/or 110 may be chosen such that both carrier amplifier 104 and the peaking amplifier 106 see their optimum load resistance to provide maximum power and efficiency.

Implementation of the previously described quarter wavelength (λ/4) transmission line(s) 108 and 110 in the Doherty amplifier 100 may require placement of one or more lengthy and wide conductive paths on a mounting surface of a substrate. As such, each quarter wavelength (λ/4) transmission line 108 and 110 may consume a significant amount of area on the mounting surface, which may impose limitations on the minimum footprint size of the Doherty amplifier 100 and which may present difficult challenges with respect to reducing the footprint size.

In addition, the quarter wavelength (λ/4) transmission line(s) 108 and 110 that are typically implemented in conventional Doherty amplifiers may not apply a constant phase shift (e.g., an approximately 90-degree phase shift) over a range of frequencies. For example, if the frequency of an RF signal deviates from the center frequency for which the transmission line 108 or 110 is designed to apply an intended phase shift of approximately 90 degrees, the quarter wavelength (λ/4) transmission line may apply a phase shift that is different than the intended phase shift. This phase shift difference may result in phase misalignment between the carrier and peaking signals at the combining node 112, which may reduce the efficiency of the Doherty amplifier 112 and degrade performance.

As indicated in FIG. 1A, some or all components of Doherty amplifier 100 may be implemented in a single device package or module. For example, the box drawn around the circuit elements of the power amplifier 100 may represent a substrate of the single device package or module. When incorporated into a larger RF system, the RF input node 116 may be coupled to an RF signal source (not illustrated), and the RF output node 118 at the output of the output transformer 114 may be coupled to the load 120 (e.g., an antenna or other load). The RF signal source may provide the RF input signal (RF_IN), which is an analog signal that includes spectral energy that typically is centered around one or more carrier frequencies. Fundamentally, the Doherty amplifier 100 is configured to amplify the RF input signal, and to produce an amplified RF output signal at the RF output node 118.

As discussed above, the transmission lines 108 and 110 and the transformer 114 may consume a large amount of circuit real estate. An example of a circuit topology including an embodiment of the Doherty amplifier of FIG. 1A is described below with respect to FIG. 1B.

FIG. 1B depicts a diagram of a circuit device 130 of a ninety/zero (90°/0°) Doherty power amplifier 100 including a quasi-line 132 and an output transformer 114. The Doherty power amplifier 100 includes an RF input node 116, which may correspond to an RF_IN terminal of the circuit device 130. The circuit device 130 may include a splitter 102 that is coupled to the RF input node 116. The splitter 102 is shown in phantom because the splitter 102 is not necessarily drawn to scale and may vary based on the circuit implementation of the splitter 102.

The circuit device 130 may include the carrier amplifier 104 and the peaking amplifier 106, which may be coupled to outputs of the splitter 102. The circuit device 130 may include a quasi-line 132, which may include the combining node 112 and which may provide the one or more quarter-wavelength transmission lines 108 and 110 of FIG. 1A. The circuit device 130 may also include the transformer 114, which is coupled to the output node 118. The output node 118 may correspond to the RF_OUT terminal of the circuit device 130.

In the illustrated example, the carrier amplifier 104, the peaking amplifier 106, the quasi-line 132, and the transformer 114 are drawn as solid blocks, which are drawn to scale. As shown the quasi-line 132 and the transformer 114 occupy a significant amount of the footprint of the circuit device 130.

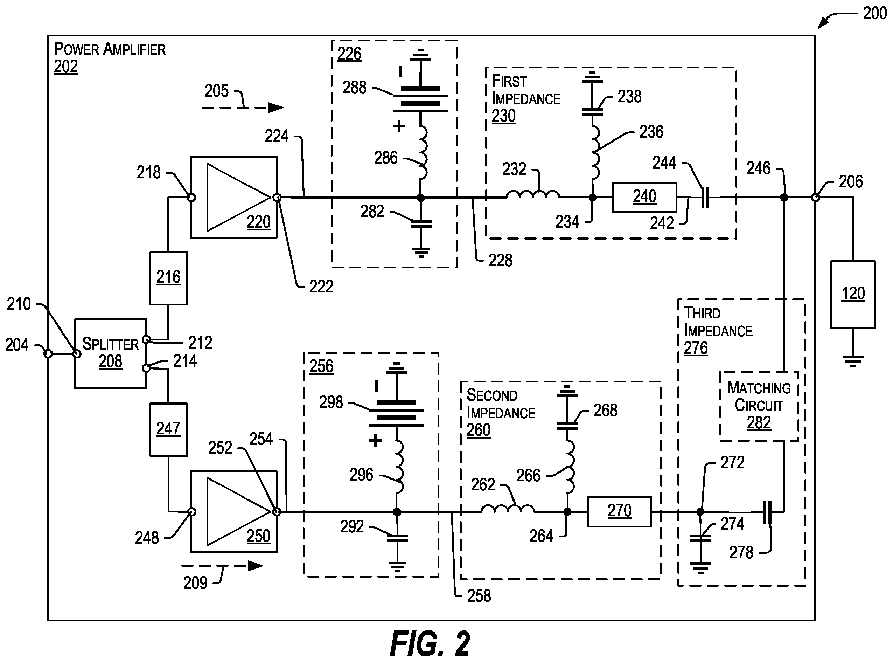

Embodiments of Doherty power amplifiers are described below that include circuit elements that provide the phase adjustments to also provide impedance matching to the output node, allowing for elimination of the quasi-line 132 and the transformer 114, reducing the footprint of the Doherty power amplifier. An embodiment of the Doherty power amplifier is described below with respect to FIG. 2.

FIG. 2 depicts a diagram 200 of an embodiment of a Doherty power amplifier 202 including three impedance circuits 230, 260, and 276 to enable an output impedance match without an output transformer, in accordance with certain embodiments. The Doherty power amplifier 202 may be implemented in a single device package or module. The power amplifier 202 may include an input node 204 to receive an RF input signal and an output node 206 to provide an RF output signal to an output load 120.

The power amplifier 202 may include a power splitter 208, which has an input 210 and two outputs 212 and 214. The power splitter input 208 may be coupled to the RF input node 204 to receive the input RF signal. The power splitter 208 may be configured to divide the RF input signal received at input 210 into first and second RF signals, which may have equal or unequal power. In one example implementation, the power splitter 208 may include a 90-degree hybrid coupler (also referred to as a "hybrid coupler") to divide the RF input signal and to achieve a phase difference between the RF output signals in a small footprint. Such a hybrid coupler may maintain a quasi-constant phase difference (e.g., a phase difference of 90 degrees) between a through port of the hybrid coupler (to output 212) and a coupled port of the hybrid coupler (to output 214) over a range of frequencies.

The first RF signal (also referred to as a "carrier signal") may be provided to a first amplifier die 220 (also referred to as a "carrier amplifier die 220" or "carrier amplifier 220") through the output 212 and the second RF signal (also referred to as a "peaking signal") may be provided to a second amplifier die 250 (also referred to as a "peaking amplifier die 250" or "peaking amplifier 250") through the output 214. In some embodiments, the power splitter 208 may include one or more phase shift elements configured to impart one or more phase shifts to the first and second RF signals to establish a phase difference (also referred to as a phase delay) between the first and second RF signals at the outputs 212 and 214 (e.g., a phase shift of approximately 90 degrees). Accordingly, in one example, the first RF signal provided to the input 218 of the carrier amplifier die 220 may be approximately 90 degrees out of phase with the second RF signal provided to the input 248 of the peaking amplifier die 250.

Each amplification stage of the carrier amplifier die 220 and the peaking amplifier die 250 may include one or more power transistors. More specifically, each power transistor may include a control terminal (e.g., a gate terminal) and first and second current-carrying terminals (e.g., a drain terminal and a source terminal). In a single-stage device, which would include a single power transistor, the control terminal may be electrically connected to the input terminal 218, 248, one of the current-carrying terminals (e.g., the drain terminal or the source terminal) is electrically connected to the output terminal 224, 254, and the other current-carrying terminal (e.g., the source terminal or the drain terminal) is electrically connected to a supply voltage (e.g., a ground reference or another voltage reference). Conversely, a two-stage device would include two power transistors coupled in series, where a first transistor functions as a driver amplifier transistor that provides relatively high gain amplification, and a second transistor functions as an output amplifier transistor that provides relatively low gain amplification. In such an embodiment, the control terminal of the driver amplifier transistor may be electrically connected to the input terminal 218, 248, one of the current-carrying terminals of the driver amplifier transistor (e.g., the drain terminal or the source terminal) may be electrically connected to the control terminal of the output amplifier transistor, and the other current-carrying terminal of the driver amplifier transistor (e.g., the source terminal or the drain terminal) may be electrically connected to supply voltage (e.g., a ground reference or another voltage reference). Additionally, one of the current-carrying terminals of the output amplifier transistor (e.g., the drain terminal or the source terminal) may be electrically connected to the output terminal 224, 254, and the other current-carrying terminal of the output amplifier transistor (e.g., the source terminal or the drain terminal) may be electrically connected to a supply voltage (e.g., a ground reference or another voltage reference).

In one or more embodiments, an input matching circuit 216 may be implemented as part of the carrier amplifier die 220 or between the output 212 of the splitter 208 and the input 218 of the carrier amplifier die 220 (as shown). In one or more embodiments, the input matching circuit 216 may be configured to match the terminal impedance of its input terminal to the input impedance of the carrier amplifier die 220. In one or more embodiments, in addition to impedance matching, the input matching circuit 216 be configured to provide a selected phase compensation. In an example, the input matching circuit 216 may apply a phase shift (e.g., phase delay) of approximately 90 degrees to the first RF signal (e.g., the carrier signal) between the output 212 of the splitter 208 and the input 218 of the carrier amplifier die 220.

In one or more embodiments, the power amplifier 202 may include an input matching circuit 247, which may be implemented as part of the peaking amplifier die 250 or between the output 214 of the splitter 208 and the input 248 of the peaking amplifier die 250 (as shown). In one or more embodiments, the input matching circuit 247 may be configured to match the terminal impedance of its input terminal to the input impedance of the peaking amplifier die 250. In one or more embodiments, in addition to impedance matching, the input matching circuit 247 may be configured to provide a selected phase compensation, such as a selected phase shift (e.g., a second phase delay) between the output 214 of the splitter 208 and the input 248 of the peaking amplifier die 250.

When the Doherty power amplifier 202 has a symmetrical configuration (i.e., a configuration in which the carrier amplifier die 220 and the peaking amplifier die 250 include power transistors that are substantially identical in size or power handling capability), the power splitter 208 may divide or split the input RF signal received at the input 210 into two signals that have approximately equal power. Conversely, when Doherty amplifier 202 has an asymmetrical configuration (i.e., a configuration in which the peaking amplifier die 250 includes a power transistor that is significantly larger than the power transistor in the carrier amplifier die 220), the power splitter 208 may output signals having unequal power. In some embodiments, the power splitter 208 may be implemented with fixed-value, passive components. In other embodiments, the power splitter 208 may be implemented with one or more controllable variable attenuators and/or variable phase shifters, which enable the power splitter 208 to attenuate and/or phase shift the first and second RF signals based on externally-provided control signals.

As shown in FIG. 2, the Doherty power amplifier 202 may include the carrier amplifier die 220 and the peaking amplifier die 250, according to an embodiment. Each amplifier die 220 and 250 includes an input terminal 218, 248 proximate to a first edge of the amplifier die 220, 250, and output terminal 222, 252 proximate to a second edge of the amplifier die 220, 250. Each amplifier die 220, 250 may include one or more power transistors electrically connected between the input terminal 218, 248 and the output terminals 222, 252.

The outputs 212, 214 of the power splitter 208 are connected to a first signal path 205 and a second signal path 209, respectively. The first signal path 205 includes a first input matching circuit 216, the carrier amplifier die 220, a first output matching circuit 226, and a first impedance circuit 230. In some embodiments, the first input matching circuit 216 may include a plurality of discrete and/or integrated components (e.g., inductors and capacitors) configured to provide impedance matching between the output 212 of the power splitter 208 and the input 218 to the carrier amplifier die 220. In one or more embodiments, the first input matching circuit 216 may include a capacitor implemented as a high pass filter between the output 212 and the input 218 and a direct current (DC) feed coupled to the input 218.

The carrier amplifier die 220 is configured to receive the first RF signal from the power splitter 208 at input terminal 218 via the first input matching circuit 216, to amplify the first RF signal, and to provide the amplified first RF signal at the output terminal 222. The amplified first RF signal is conveyed from the output terminal 222 to a first output matching circuit 226 via a first signal line 224. The first output matching circuit 226 may be configured to match the terminal impedance of its input terminal at the output terminal 222 of the carrier amplifier die 220 to the terminal impedance of its output node 228.

In some embodiments, at least a portion of the first signal line 224 may be implemented as a wire bond array including a plurality of parallel wires that extend from a bonding pad coupled to the output terminal 222 to a conductive trace or contact on the substrate of the Doherty amplifier 202. The first output matching circuit 226 may include one or more discrete and/or integrated components (e.g., capacitors, inductors, and/or resistors) configured to provide the selected impedance matching between the output of the carrier amplifier die 220 and a node 228.

In the illustrated example, the first output matching circuit 226 may include a capacitor 282 including a first terminal coupled to the first signal line 224 and including a second terminal coupled to a power supply terminal, such as ground. The capacitor 282 may represent a drain-source capacitance (Cds) of a transistor of the carrier amplifier die 220. The first output matching circuit 226 may include an inductor 286 including a first terminal coupled to the first signal line 224 and a second terminal coupled to a power supply 288, such as a multi-cell battery or other signal source. In this example, the power supply 288 and the inductor 286 may be configured to inject a direct current (DC) feed to the first signal line 224.

In one or more embodiments, the capacitor 282 may have a negative capacitance, and a capacitor 244 may have a positive capacitance. The capacitor 282 may be a shunt capacitor having a negative capacitance value that may represent an amount of capacitance that is to be reduced from the capacitor 244 having the positive capacitance value. In this example, the capacitor 282 is a shunt capacitor with a negative capacitance value that is the capacitor 244 having a positive capacitance value through the first impedance circuit 230. A negative capacitance means a positive voltage across the terminals of the capacitor 282 when a charge applied to the first signal line 224 is negative. When a negative capacitance value of the capacitor 282 is reduced from the capacitor 244 having a positive capacitance value, the capacitor 244 may be said to absorb the negative capacitance value.

The power amplifier 202 may include a first impedance circuit 230 coupled between the node 228 and a combining node 246, which may be connected (shorted) to the output 206. In one or more embodiments, the first impedance circuit 230 may include one or more discrete and/or integrated components (e.g., capacitors, inductors, and/or resistors) configured to provide the selected impedance matching and to impart a desired phase shift to the RF signal at the node 228.

In the illustrated embodiment of FIG. 2, the first impedance circuit 230 may include an inductor 232 coupled between the node 228 and a node 234, which inductor 232 may represent a wire inductance of the wire trace. The first impedance circuit 230 may also include an inductor 236 including a first terminal coupled to the node 234 and a second terminal, which may be coupled to a first terminal of a capacitor 238 that includes a second terminal coupled to a supply voltage terminal (such as ground). In one or more embodiments, the inductor 236 may provide a shunt inductance. The first impedance circuit 230 may include a microstrip transmission line 240 coupled between the node 234 and a node 242 and a capacitor 244 coupled between the node 242 and the combining node 246. The inductance of the inductor 236 may be balanced with the transmission line 240 and may be selected to provide a selected impedance and a selected phase difference from the output of the carrier amplifier die 220 to the combining node 246. It should be appreciated that the selected impedance provided by the first impedance circuit 230 may account for the periphery of the circuit device such that the parasitic is absorbed into the impedance provided by the first impedance circuit 230, creating a compact implementation.

The second signal path 209 is similarly configured to amplify the second RF signal. The second signal path 209 may include a second input matching circuit 247, which may include one or more discrete and/or integrated components (e.g., capacitors, inductors, and/or resistors) configured to provide the selected impedance matching and optionally to impart a desired phase shift. The second signal path 209 may include the peaking amplifier die 250, which may be configured to receive the second RF signal from the power splitter 208 at input terminal 248, to amplify the second RF signal, and to provide the amplified second RF signal at the output terminal 252. The amplified second RF signal is conveyed from the output terminal 252 to a second output matching circuit 256 via a second signal line 254.

In some embodiments, at least a portion of the second signal line 254 may be implemented as a wire bond array including a plurality of parallel wires that extend from a bonding pad coupled to RF output terminal 206 to a conductive trace or contact on the substrate of the Doherty power amplifier 202. The second output matching circuit 256 may include one or more discrete and/or integrated components (e.g., capacitors, inductors, and/or resistors) configured to provide the selected impedance matching between the output of the peaking amplifier die 250 and a node 258.

In the illustrated example, the second output matching circuit 256 may include a capacitor 292 including a first terminal coupled to the second signal line 254 and including a second terminal coupled to a power supply terminal, such as ground. In one or more embodiments, the capacitor 292 may represent a drain-source capacitance (Cds) of a transistor of the peaking amplifier die 250 rather than discrete physical component. The second output matching circuit 256 may include an inductor 296 including a first terminal coupled to the second signal line 254 and a second terminal coupled to a power supply 298, such as a multi-cell battery or other signal source. In this example, the power supply 298 and the inductor 296 may provide a direct current (DC) feed to the second signal line 254.

In one or more embodiments, the capacitor 292 may have a negative capacitance. The capacitor 292 may be a shunt capacitor having a negative capacitance value that may represent an amount of capacitance that is to be reduced from a capacitor 274 having a positive capacitance value. In this example, the capacitor 292 is a shunt capacitor with a negative capacitance value that is coupled to the capacitor 274 having a positive capacitance value through a second impedance circuit 260. A negative capacitance means a positive voltage across the terminals of the capacitor 292 when a charge applied to the second signal line 254 is negative. When a negative capacitance value of the capacitor 292 is reduced from a charge stored on the capacitor 274 having a positive capacitance value, the capacitor 274 may be said to absorb the negative capacitance value.

The Doherty amplifier 202 may include a second impedance circuit 260 be coupled between the node 258 and a node 272. The second impedance circuit 260 may receive the amplified second RF signal via the node 258. In some embodiments, the second impedance circuit 260 may include one or more discrete and/or integrated components (e.g., capacitors, inductors, and/or resistors) configured to provide the desired impedance matching and to impart a desired phase shift.

In the illustrated embodiment of FIG. 2, the second impedance circuit 260 may include an inductor 262 including a first terminal coupled to the node 258 and a second terminal coupled to a node 264, which inductor 262 may represent an inductance of the wire trace. The second impedance circuit 260 may include a second inductor 266 including a first terminal coupled to the node 264 and a second terminal coupled to a first terminal of a capacitor 262 and including a second terminal coupled to a power supply terminal, such as ground. The second impedance circuit 260 may include a second transmission line 270 (e.g., a microstrip transmission line) coupled between the node 264 and a node 272. The second inductor 266 may provide a shunt inductance. In one or more embodiments, the inductance of the second inductor 266 may be balanced with the second transmission line 270 to provide a selected inductance and a selected phase difference from the output of the carrier amplifier die 250 to the node 272.

The second signal path 209 may also include a third impedance circuit 276, which may include a capacitor 274 coupled between the node 272 and a power supply terminal, such as ground. The third impedance circuit 276 may also include a capacitor 278 including a first terminal coupled to the node 272 and a second terminal coupled to the combining node 246. In one or more embodiments, the third impedance circuit 276 may optionally include additional circuitry 282, which may include one or more discrete circuit components, a microstrip transmission line, or any combination thereof between the second terminal of the capacitor 278 and the combining node 246. In some embodiments, the additional circuitry circuit 282 may be omitted and the second terminal of the capacitor 278 may be connected directly to the combining node 246. The combining node 246 may be connected to the output node 206 without any intervening impedance matching circuitry or transformer. The output node 206 may be coupled to the load 120.

In one or more embodiments, the Doherty power amplifier 202 may implement a 90°/180° Doherty amplifier without growing the physical footprint. In addition, the first impedance circuit 230, the second impedance circuit 260, and the third impedance circuit 276 may be configured to provide impedance matching at the combining node 246, such that the impedance at the combining node 246 matches the load impedance. In other words, since the combining node 246 is connected (shorted) to the output node 206 without intervening matching circuitry and without an output transformer, the impedance circuits 230, 260, and 276 provide an impedance at the combining node 246 that matches the load impedance.

In one or more embodiments, the Doherty power amplifier 202 may take advantage of the properties of the 90°/180° Doherty power amplifier, including enabling selection of characteristic impedances of the 90-degree and 180-degree branches (first signal path 205 and second signal path 209) and the impedance of the combining node 246, to provide the selected impedance matching for the output node 206. In one or more embodiments, the first impedance circuit 230 may provide a first impedance Z₁, the second impedance circuit 260 may provide a second impedance Z₂, and the third impedance circuit 276 may provide a third impedance Z₃. Taking into account the intrinsic carrier impedance Z_{c} of the carrier amplifier die 220 and the intrinsic peaking impedance Zp of the peaking amplifier die 250, the impedance *Z₀* at the output node 206 may be determined as follows: $\frac{1}{{Z}_{0}} = \frac{1}{{Z}_{1} + {Z}_{c}} + \frac{1}{{Z}_{2} + {Z}_{3} + {Z}_{p}} .$ (1) It should be appreciated that Equation 1 is a simplified representation of the impedance equation, since it does not take into account the phase angle of the impedances; however, such details are dependent on the selected configurations of the impedance circuits 230, 260, and 276 and are well-understood in the art. In the example of Equation 1, the component values of the first impedance circuit 230, the second impedance circuit 260, and the third impedance circuit 276 may be configured to provide an impedance Z₀ of fifty ohms (50Ω) looking into the combining node 246 and the output node 206 that is matched to the load impedance. Additionally, the capacitors or inductors to provide the impedance match may be selected to provide a selected phase for phase matching at the combining node 246.

By using the impedance circuits 230, 260, and 270 to provide output impedance matching, the combining node 246 may be directly connected to the output node 206 without an intervening matching circuit and without an output transformer, thereby reducing the overall circuit footprint. Additionally, by removing impedance matching circuitry between the combining node 246 and the output node 206, output losses may be reduced relative to conventional power amplifiers. Thus, the Doherty power amplifier 202 may provide a higher amplifier efficiency than conventional Doherty power amplifier 202.

In one or more embodiments, when the Doherty power amplifier 202 is used for lower power level implementations (such as, for example, a 128-transmitter (128T) or a 64T application), the output transformer 114 may be omitted without a performance trade-off. For higher power implementations (such as a 32T application), the Doherty power amplifier 202 may be used without the output transformer 114 but may have a limited amplifier bandwidth. In one or more embodiments, the Doherty amplifier 202 may be configured so that the first signal path 205 (also referred to as a carrier signal path) provides amplification for relatively low-level input signals. As the magnitude of the input signal increases, a first input power level is reached at which the second signal path 209 (also referred to as a peaking signal path) also becomes active. This may be accomplished, for example, by biasing the carrier amplifier die 220 to operate in a class AB mode, and biasing the peaking amplifier die 250 to operate in a class C mode.

In one or more embodiments, the first impedance circuit 230 may be implemented using a capacitor-transmission line-capacitor absorption method while providing a ninety-degree (90°) phase adjustment. The desired characteristic impedance may be obtained by removing the extra capacitance using the inductor 236 in parallel with the capacitor 244. Further reduction in footprint is possible by balancing the use of inductance versus transmission lines. Additionally, the capacitance of capacitor 244 may cancel out the negative capacitance from the C-bridge at the combining node 246.

In one or more embodiments, the impedance of the second signal path 209 is implemented in the second impedance circuit 260 and the third impedance circuit 276. The second impedance circuit 260 may use the capacitor-transmission line-capacitor absorption method to reduce the physical footprint. The third impedance circuit 276 may use a negative ninety degree (-90°) compact capacitive bridge. The capacitor 274 from the second impedance circuit 276 may offset the negative capacitance of the C-bridge provided by the capacitor 278. The overall phase of the signal path 209 may be zero degrees (0°) while retaining the wideband characteristics of the 90°/180° topology.

It should be appreciated that the Doherty amplifier 202 may be designed so that, during operation, the amplified first and second RF signals combine substantially in phase at the combining node 246 to produce an amplified and combined RF output signal. As shown in FIG. 2, the combining node 246 is electrically connected to the RF output node 206 to provide the amplified and combined RF output signal directly to the RF output node 206. In an embodiment, the first impedance circuit 230 may adjust the phase of the first output signal from the carrier amplifier die 220 and the second impedance circuit 260 and the third impedance circuit 276 may adjust the phase of the second output signal from the peaking amplifier die 250 so that the first and second output signals combine in phase at the combining node 246 while also functioning to present a selected load impedance to the output node 206. The resulting amplified RF output signal at the combining node 246 may be provided to the output node 206 without intervening impedance matching or transformer circuitry, and the output load 120 (e.g., an antenna or other circuit) may be connected directly to the output node 206.

In a particular illustrative, non-limiting implementation, the components of the first impedance circuit 230 may be selected to have an impedance of approximately 63.518 Ohms. The components of the second impedance circuit 260 may be selected to have an impedance of approximately 35.581 Ohms and the components of the third impedance circuit 276 may be selected to have an impedance of approximately 84.026 Ohms. The carrier intrinsic impedance *Z_{c}* may be approximately 94.138 Ohms. The peaking intrinsic impedance *Zₚ* of the peaking amplifier 250 may be approximately 65.906 Ohms. It should be appreciated that the above values are provided for illustrative purposes only and are not intended to be limiting.

At the combining node 246, the effective impedance may be approximately fifty Ohms (50Ω). At 3.4 Gigahertz (GHz), the output loss may be approximately -0.193 decibel-milliwatts (dBm). At 3.6 GHz, the output loss may be approximately -0.196 dBm. At 3.8 GHz, the output loss may be approximately -0.207 dBm. Over this range of frequencies, the output loss is very small. In one or more embodiments, the Doherty power amplifier 202 may show high efficiency and wide bandwidth over an input frequency range from 3.4 to 3.8 GHz.

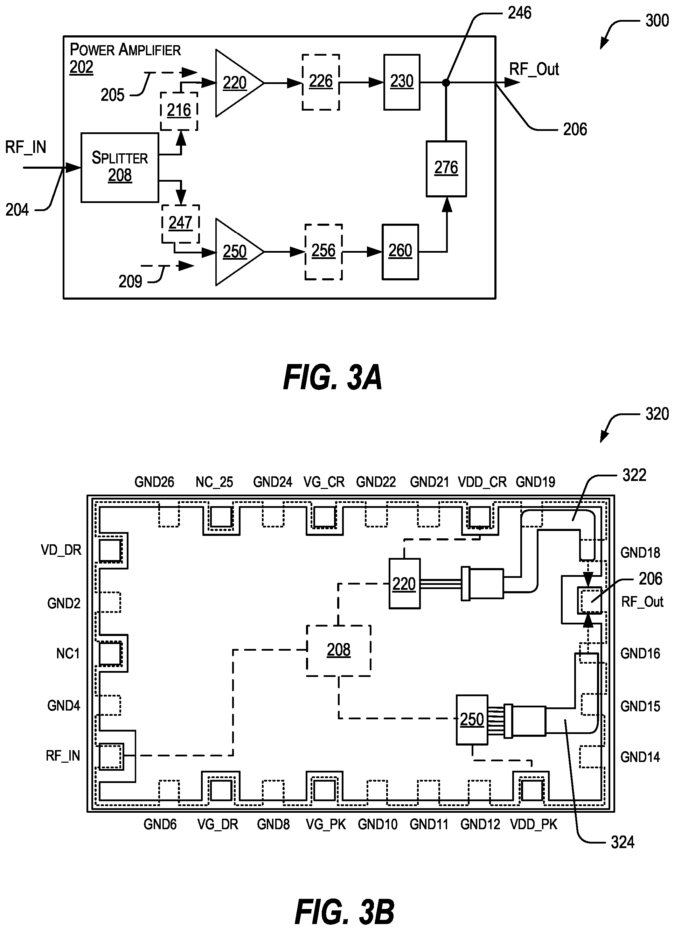

FIG. 3A depicts a diagram of a circuit layout 300 including the Doherty power amplifier 202 of FIG. 2, in accordance with certain embodiments. In this example, the power amplifier 202 includes an input node 204 configured to receive a radio frequency (RF) input signal (RF_IN) and an output node 206. The Doherty power amplifier 202 may include a splitter 208 including an input coupled to the input node 208, a first output coupled to a first signal path 205, and a second output coupled to a second signal path 209. The first signal path 205 may include the first output coupled to an input of a first input matching circuit 216 that includes an output coupled to an input of the carrier amplifier die 220. The carrier amplifier die 220 may include an output coupled to an input of a first output matching circuit 226, which may include an output coupled to an input of a first impedance circuit 230. The first impedance circuit may include an output coupled to the combining node 246.

The second signal path 209 may include the second output of the splitter 208 coupled to an input of a second impedance matching circuit 247, which may include an output coupled to an input of the peaking amplifier die 250. The peaking amplifier die 250 may include an output coupled to an input of a second output matching circuit 256, which may include an output coupled to an input of a second impedance circuit 260. The second impedance circuit 260 may include an output coupled to an input of a third impedance circuit 275, which may include an output coupled to the combining node 246. The combining node 246 may be connected directly to the output node 206 without intervening impedance matching circuitry and without a transformer circuit.

In one or more embodiments, circuit elements that form the first impedance circuit 230, the second impedance circuit 260, and the third impedance circuit 276 may be selected in conjunction with the intrinsic impedances of the carrier amplifier die 220 and the peaking amplifier die 250 to provide a selected impedance at the combining node 246 to match of the load impedance coupled to the output node 206. In one or more embodiments, the impedance at the combining node 246 may be approximately fifty ohms (50Ω) to match a transmission line impedance of the load 120 coupled to the output node 206.

In the illustrated example of FIG. 3A, the first input matching circuit 216 and the first output matching circuit 226 are shown in phantom because they may be incorporated in the carrier amplifier die 220. Similarly, the second input matching circuit 247 and the second output matching circuit 256 are shown in phantom because they may be incorporated in the peaking amplifier die 250. In one or more embodiments, the output matching circuits 226 and 256 may include circuit components selected to adjust the intrinsic carrier impedance and the intrinsic peaking impedance to further refine the output impedance looking into the output node 206.

FIG. 3B depicts a diagram of a circuit topology 320 of a ninety/one hundred eighty (90°/180°) Doherty power amplifier 202 with a reduced footprint, in accordance with certain embodiments. The circuit topology 300 includes the splitter 208, the carrier amplifier die 220 and the peaking amplifier die 250. The carrier amplifier die 220 includes an input coupled to a first output of the splitter 208 and an output coupled to a first signal path 322 extending between the output of the carrier amplifier die 220 and the output node 206. The first signal path 322 may include the first impedance circuit 230 in FIG. 2. In this example, the combining node 246 and the output node 206 may be the same.

The peaking amplifier die 250 may include an input coupled to a second output of the splitter 208 and an output coupled to a second signal path 324 extending between the output of the peaking amplifier die 250 and the output node 206. The second signal path 324 may include the second impedance circuit 230 and the third impedance circuit 276.

As compared to the diagram 130 in FIG. 1B, the circuit topology 320 in FIG. 3B is significantly smaller. The omission of the transformer circuit frees a significant amount of circuit real estate. In other implementations, the dimensions of the circuit may be reduced or, alternatively, other circuitry may be integrated with the circuit topology 320 to take advantage of the available space. In one or more embodiments, the Doherty power amplifier 202 shown in FIG. 3A may take advantage of the properties of a 90°/180° Doherty power amplifier to remove the transformer (shown in FIGs. 1A and 1B) and combine those properties with the capacitive-bridge concept to reduce the physical footprint as can be readily observed in FIG. 3B.

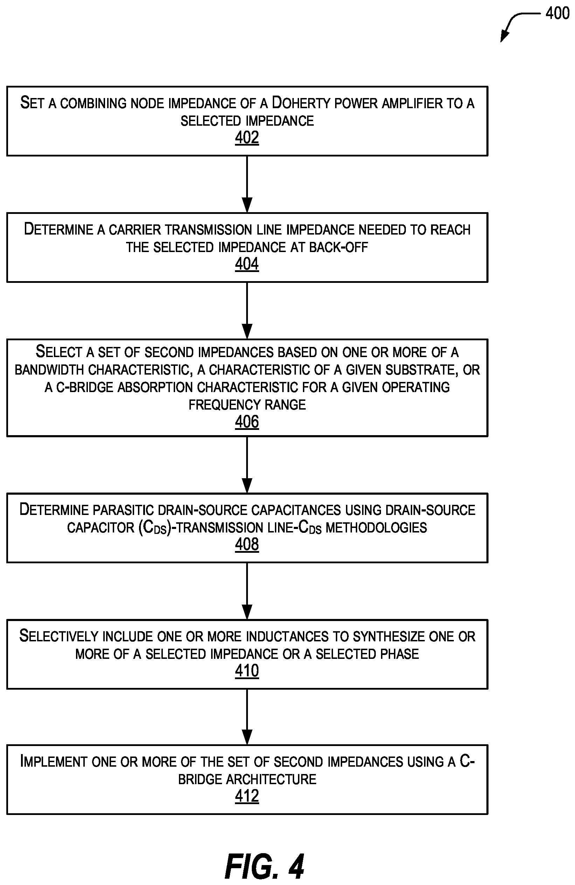

FIG. 4 depicts a flow diagram of a method 400 of designing a Doherty power amplifier having a compact topology, in accordance with certain embodiments. At 402, the method 400 may include setting a combining node impedance of a Doherty power amplifier to a selected impedance. In one or more embodiments, the selected impedance may correspond to a standard transmission line impedance, such as fifty ohms (50Ω). In other embodiments, the selected impedance may be determined to match an impedance of a load 120.

At 404, the method 400 may include determining a carrier transmission line impedance needed to reach the selected impedance at back-off. In one or more embodiments, operation of the Doherty amplifier 202 at power levels below the full-power output condition is referred to as "back-off operation." Accordingly, the carrier line impedance may be determined at one or more power levels below the full-power output condition.

At 406, the method 400 may include selecting a set of second impedances based on one or more of a bandwidth characteristic, a characteristic of a given substrate, or a c-bridge absorption characteristic for a given operating frequency range. In an example, the circuit components and configuration of those components for the second impedance circuit 260 and the third impedance circuit 276 may be selected, in conjunction with the intrinsic peaking impedance to achieve a selected impedance at the combining node 247.

At 408, the method 400 may include determining parasitic drain-source capacitances using drain-source capacitor (Cds)-transmission line (TLIN)-Cds methodologies. In one or more embodiments, the Cds-TLIN-Cds topology may include the the capacitor 292, the transmission line 270, and the capacitor 274 in the second signal path 209. In one or more implementations, the carrier line impedance may include the intrinsic carrier impedance as well as a selected impedance of the first impedance circuit 230. In one or more embodiments, the peaking carrier impedance may also be determined.

At 410, the method 400 may include selectively including one or more inductances to synthesize one or more of a selected impedance or a selected phase. The inductances may be selected to provide a selected impedance and/or a selected phase for each impedance circuit 230, 260, and 276.

At 412, the method 400 may include implementing one or more of the set of second impedances using a capacitance-bridge architecture. The second impedance circuit 260 may provide a 90-degree phase adjustment and may utilize an absorption method provided by the drain-source capacitance (Cds) of the peaking amplifier die 250, the transmission line 270, and the Cds represented by the capacitor 274 to reduce the physical footprint. The third impedance circuit 276 may provide a negative 90-degree phase adjustment and may use a negative 90-degree compact capacitive-bridge concept such that a mirror capacitance provided by the capacitor 274 offsets a negative capacitance of the capacitive-bridge provided by the capacitor 292. The overall phase of the peaking path is zero degrees while retaining the wideband characteristics of the 90/180 topology.

In one or more embodiments, the power amplifier 202 may include a lower output loss compared to existing solutions, leading to higher efficiency. In one or more embodiments, the power amplifier 202 may have an output loss of approximately 0.2 decibels (dB) from the intrinsic drain of the carrier amplifier circuit 220 to the fifty-ohm (50Ω) output terminal 206 as compared to the typical 0.5 dB loss seen with Doherty power amplifier modules that include an output transformer. Further, the power amplifier 202 exhibits a wideband with high efficiency at 39 dBm (decibel-milliwatts) and a tight spread across a frequency band from 3.4 gigahertz (GHz) to 3.8 GHz.

In one or more embodiments, the Doherty power amplifier circuit 202 includes a first impedance circuit 230, a second impedance circuit 260, and a third impedance circuit 276. The first impedance circuit 230 is coupled between a carrier amplifier die 220 and a combining node 246 that is connected to an output terminal 206 of the circuit 202. The second impedance circuit 260 includes an input coupled to an output of a peaking amplifier 250 and includes an output. The third impedance circuit 276 is coupled between the output of the second impedance circuit 260 and the combining node 246. The first impedance circuit 230 provides a first impedance and the second impedance circuit 260 and the third impedance circuit 276 provide a second impedance to the combining node 246 to produce an output impedance configured to match a load impedance of a load 120 at (coupled to) the output terminal 206. In an embodiment, the first impedance circuit 230 provides a ninety-degree phase offset and the second impedance circuit 260 and the third impedance circuit 276 together provide a zero-degree phase offset. In one or more embodiments, the power amplifier circuit 202 may provide a wider bandwidth than existing power amplifier modules based on 90/0 topology. Additionally, in one or more embodiments, the power amplifier circuit 202 may be used to implement a 90/180 topology while providing a smaller physical footprint than conventional 90/180 Doherty power amplifiers, especially those including an output transformer.

In one or more embodiments, the Doherty power amplifier 202 may take advantage of the properties of the 90/180 Doherty amplifier topology, namely, the freedom to select the characteristic impedances of the 90-degree and 180-degree branches and the combining node impedance. In one or more embodiments, the combining node impedance is selected to be fifty ohms (50Ω), which matches the impedance of the combining node 246 to that of the output terminal 206, enabling elimination of an output transformer or other impedance matching circuitry between the combining node 246 and the output terminal 206. The lower power level (for example 128T and 64T applications) can be implemented with the power amplifier circuit 202 without performance trade-off. For higher power 32T applications, the power amplifier circuit 202 may be used with a reduced amplifier bandwidth.

In one or more embodiments, the first signal path 205 including the carrier amplifier die 230, the output matching circuit 226, and the first impedance circuit may provide the ninety-degree phase offset using the Cds-TLIN-Cds absorption methodology (capacitor 282 - transmission line 240 - capacitor 244). In one or more embodiments, a selected characteristic impedance may be obtained using the shunt inductor 236 in parallel with the capacitor 282. In one or more embodiments, further reduction in the footprint of the power amplifier circuit 202 is possible by balancing the inductance of the inductor 236 versus the characteristics of the transmission line 240. Lastly, the Cds mirroring capacitance cancels out the negative capacitance from the C-bridge at the combining node 146.

In one or more embodiments, the amplifier circuit 202 may include a peaking 180-degree path between the peaking amplifier die 250 and the combining node 246. The peaking 180-degree path may include the second impedance circuit 260 and the third impedance circuit 276. The second impedance circuit 260 may utilize the Cds-TLIN-Cds (drain-source capacitor 292 - transmission line 270 - capacitor 274) absorption method to reduce the physical footprint. The third impedance circuit 276 may provide a negative 90-degree compact capacitive-bridge (capacitors 274 and 278) concept. In one or more embodiments, the mirror capacitance 292 may offset a negative capacitance of the C-bridge on the peaking side. The overall phase offset of the second path is zero degrees while retaining the wideband characteristics of the 90/180 topology.

This disclosure may be further understood in light of the following examples.
Example 1: A Doherty power amplifier circuit includes a combining node connected to an output terminal; an input terminal to receive an input signal a splitter circuit including a splitter input coupled to the input terminal, a first splitter output, and a second splitter output; a carrier amplifier circuit including a first amplifier input and a first amplifier output; a peaking amplifier circuit including a second amplifier input and a second amplifier output; a first impedance circuit including a first impedance input coupled to the first amplifier output and including a first impedance output coupled to the combining node; a second impedance circuit including a second impedance input coupled to the second amplifier output and including a second impedance output; and a third impedance circuit including a third impedance input coupled to the second impedance output and including a third impedance output coupled to the combining node; where a first impedance of the first impedance circuit and a second impedance of the second impedance circuit and the third impedance circuit at the combining node produce an output impedance configured to match a load impedance of a load at the output terminal.
Example 2: The Doherty power amplifier circuit of Example 1, further including the second impedance circuit is configured to provide a ninety-degree phase adjustment; the third impedance circuit is configured to provide a negative ninety-degree phase adjustment; where the second impedance has a zero-degree phase offset relative to a peaking amplifier output signal; and where the Doherty power amplifier circuit comprises a ninety-one hundred eighty (90° -180°) Doherty amplifier.
Example 3: The Doherty power amplifier circuit of any of the preceding Examples, where the first impedance circuit is configured to provide the first impedance at back-off when a selected impedance of the combining node is fifty ohms.
Example 4: The Doherty power amplifier circuit of any of the preceding Examples, where a first signal path at the first amplifier output includes a first output matching circuit including: a first capacitor including a first terminal coupled to the first amplifier output and including a second terminal coupled to a first supply voltage; and an inductor including a first inductor terminal coupled to the first amplifier output and including a second inductor terminal coupled to a second supply voltage.
Example 5: The Doherty power amplifier circuit of any of the preceding Examples, where the first impedance circuit includes: a first inductor including a first inductor terminal coupled to the first amplifier output and including a second inductor terminal coupled to a node; a second inductor including a third inductor terminal coupled to the node and including a fourth inductor terminal; a first capacitor including a first capacitor terminal coupled to the fourth inductor terminal and including a second capacitor terminal coupled to a supply voltage; a microstrip transmission line including a first transmission line terminal coupled to the node and including a second transmission line terminal; and a second capacitor including a third capacitor terminal coupled to the second transmission line terminal and including a fourth capacitor terminal coupled to the combining node.
Example 6: The Doherty power amplifier circuit of Example 5, further including: an output matching circuit coupled between the first amplifier output and the first terminal of the first capacitor; and where the output matching circuit and the first impedance circuit absorb a parasitic drain-source capacitance.
Example 7: The Doherty power amplifier circuit of Example 5, where an inductance of the first inductor is selected to provide a selected impedance and a selected phase.
Example 8: The Doherty power amplifier circuit of Example 5, where the second impedance circuit includes: a third inductor including a fifth inductor terminal coupled to the second amplifier output and including a sixth inductor terminal coupled to a second node; a fourth inductor including a seventh inductor terminal coupled to the second node and including an eighth inductor terminal; a third capacitor including a fifth capacitor terminal coupled to the eighth inductor terminal and including a sixth capacitor terminal coupled to a third supply voltage; a second microstrip transmission line including a third transmission line terminal coupled to the second node and including a fourth transmission line terminal.
Example 9: The Doherty power amplifier circuit of Example 8, where the third impedance circuit includes: a fourth capacitor including a seventh capacitor terminal coupled to the fourth transmission line terminal and including an eighth capacitor terminal coupled to a fourth supply voltage; and a fifth capacitor including a ninth capacitor terminal coupled to the fourth transmission line terminal and including a tenth capacitor terminal coupled to the combining node.
Example 10: The Doherty power amplifier circuit of Example 9, where the third impedance circuit further includes a matching circuit coupled between the tenth capacitor terminal and the combining node.
Example 11: The Doherty power amplifier circuit of any of the preceding Examples, where the Doherty power amplifier circuit has an output loss of approximately 0.2 decibels.
Example 12: A method of amplifying an input signal, the method including: receiving an input signal at an input terminal of a Doherty power amplifier circuit; dividing, using a splitter circuit of the Doherty power amplifier circuit, the input signal into a first signal and a second signal having a selected power ratio; providing the first signal to a carrier input of a carrier amplifier circuit of the Doherty power amplifier circuit, the carrier amplifier circuit including a carrier output; providing the second signal to a peaking input of a peaking amplifier circuit of the Doherty power amplifier circuit, the peaking amplifier circuit including a peaking output; applying a first impedance to a first amplified signal at the carrier output using a first impedance circuit coupled between the carrier output and a combining node that is connected to an output terminal of the Doherty power amplifier circuit, the first impedance circuit configured to provide a ninety-degree phase offset to produce a first output signal at the combining node; applying a second impedance to a second amplified signal at the peaking output using a second impedance circuit coupled to the peaking output, the second impedance circuit configured to provide a ninety-degree phase offset to produce a third signal; and applying a third impedance to the third signal using a third impedance circuit coupled between the second impedance circuit and the combining node, the third impedance circuit configured to provide a negative ninety-degree phase offset to produce a second output signal at the combining node.
Example 13: The method of Example 12, where the Doherty power amplifier circuit has an output loss of approximately 0.2 decibels.
Example 14: The method of any of the preceding Examples, where the second impedance and the third impedance combine to provide an effective impedance that has a zero-degree phase offset relative to the second amplified signal.
Example 15: The method of any of the preceding Examples, where the Doherty power amplifier circuit includes a ninety-one hundred eighty (90° -180°) Doherty amplifier.
Example 16: The method of any of the preceding Examples, where an impedance of the output terminal matches a load impedance of a load coupled to the output terminal.
Example 17: The method of any of the preceding Examples, where applying the first impedance includes absorbing a parasitic drain-source capacitance of the carrier amplifier circuit.
Example 18: The method of any of the preceding Examples, where applying the second impedance includes absorbing a parasitic drain-source capacitance of the peaking amplifier circuit.
Example 19: The method of any of the preceding Examples, further including selecting an inductance of an inductor of the first impedance circuit to provide a selected impedance and a selected phase of the first impedance.
Example 20: The method of any of the preceding Examples, further including selecting an inductance of an inductor of the second impedance circuit to provide a selected impedance and a selected phase of the second impedance circuit; and selecting a first capacitance of a shunt capacitor and a second capacitance of a series capacitor, the shunt capacitor coupled to an output of the second impedance circuit and a supply voltage, the series capacitor coupled between the output of the second impedance circuit and the combining node; and where the inductance, the first capacitance, and the second capacitance determine a selected impedance and a zero-degree offset between the peaking output and the combining node.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The term "approximately" when referred to an entity or parameter may mean that the respectively entity or parameter has a value which is within 2% (when referring to a phase), or within 5% or, within 10% of the cited value.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. A Doherty power amplifier circuit comprising:
a combining node connected to an output terminal;
an input terminal to receive an input signal;
a splitter circuit including a splitter input coupled to the input terminal, a first splitter output, and a second splitter output;
a carrier amplifier circuit including a first amplifier input and a first amplifier output;
a peaking amplifier circuit including a second amplifier input and a second amplifier output;
a first impedance circuit including a first impedance input coupled to the first amplifier output and including a first impedance output coupled to the combining node;
a second impedance circuit including a second impedance input coupled to the second amplifier output and including a second impedance output; and
a third impedance circuit including a third impedance input coupled to the second impedance output and including a third impedance output coupled to the combining node;
wherein a first impedance of the first impedance circuit and a second impedance of the second impedance circuit and the third impedance circuit at the combining node produce an output impedance configured to match a load impedance of a load at the output terminal.

2. The Doherty power amplifier circuit of claim 1, further comprising:
the second impedance circuit is configured to provide a ninety-degree phase adjustment;
the third impedance circuit is configured to provide a negative ninety-degree phase adjustment;
wherein the second impedance has a zero-degree phase offset relative to a peaking amplifier output signal; and
wherein the Doherty power amplifier circuit comprises a ninety-one hundred eighty, 90° -180°, Doherty amplifier.

3. The Doherty power amplifier circuit of claim 1 or 2, wherein the first impedance circuit is configured to provide the first impedance at back-off when a selected impedance of the combining node is fifty ohms.

4. The Doherty power amplifier circuit of any preceding claim, wherein a first signal path at the first amplifier output comprises a first output matching circuit including:
a first capacitor including a first terminal coupled to the first amplifier output and including a second terminal coupled to a first supply voltage; and
an inductor including a first inductor terminal coupled to the first amplifier output and including a second inductor terminal coupled to a second supply voltage.

5. The Doherty power amplifier circuit of any preceding claim, wherein the first impedance circuit comprises:
a first inductor including a first inductor terminal coupled to the first amplifier output and including a second inductor terminal coupled to a node;
a second inductor including a third inductor terminal coupled to the node and including a fourth inductor terminal;
a first capacitor including a first capacitor terminal coupled to the fourth inductor terminal and including a second capacitor terminal coupled to a supply voltage;
a microstrip transmission line including a first transmission line terminal coupled to the node and including a second transmission line terminal; and
a second capacitor including a third capacitor terminal coupled to the second transmission line terminal and including a fourth capacitor terminal coupled to the combining node.

6. The Doherty power amplifier circuit of claim 5, further comprising:
an output matching circuit coupled between the first amplifier output and the first terminal of the first capacitor; and
wherein the output matching circuit and the first impedance circuit absorb a parasitic drain-source capacitance.

7. The Doherty power amplifier circuit of claim 5, wherein an inductance of the first inductor is selected to provide a selected impedance and a selected phase.

8. The Doherty power amplifier circuit of claim 5 or 6, wherein the second impedance circuit comprises:
a third inductor including a fifth inductor terminal coupled to the second amplifier output and including a sixth inductor terminal coupled to a second node;
a fourth inductor including a seventh inductor terminal coupled to the second node and including an eighth inductor terminal;
a third capacitor including a fifth capacitor terminal coupled to the eighth inductor terminal and including a sixth capacitor terminal coupled to a third supply voltage; and
a second microstrip transmission line including a third transmission line terminal coupled to the second node and including a fourth transmission line terminal.

9. The Doherty power amplifier circuit of claim 8, wherein the third impedance circuit comprises:
a fourth capacitor including a seventh capacitor terminal coupled to the fourth transmission line terminal and including an eighth capacitor terminal coupled to a fourth supply voltage; and
a fifth capacitor including a ninth capacitor terminal coupled to the fourth transmission line terminal and including a tenth capacitor terminal coupled to the combining node.

10. The Doherty power amplifier circuit of claim 9, wherein the third impedance circuit further includes a matching circuit coupled between the tenth capacitor terminal and the combining node.

11. The Doherty power amplifier circuit of any preceding claim, wherein the Doherty power amplifier circuit has an output loss of approximately 0.2 decibels.

12. A method of amplifying an input signal, the method comprising:
receiving an input signal at an input terminal of a Doherty power amplifier circuit;
dividing, using a splitter circuit of the Doherty power amplifier circuit, the input signal into a first signal and a second signal having a selected power ratio;
providing the first signal to a carrier input of a carrier amplifier circuit of the Doherty power amplifier circuit, the carrier amplifier circuit including a carrier output;
providing the second signal to a peaking input of a peaking amplifier circuit of the Doherty power amplifier circuit, the peaking amplifier circuit including a peaking output;
applying a first impedance to a first amplified signal at the carrier output using a first impedance circuit coupled between the carrier output and a combining node that is connected to an output terminal of the Doherty power amplifier circuit, the first impedance circuit configured to provide a ninety-degree phase offset to produce a first output signal at the combining node;
applying a second impedance to a second amplified signal at the peaking output using a second impedance circuit coupled to the peaking output, the second impedance circuit configured to provide a ninety-degree phase offset to produce a third signal; and
applying a third impedance to the third signal using a third impedance circuit coupled between the second impedance circuit and the combining node, the third impedance circuit configured to provide a negative ninety-degree phase offset to produce a second output signal at the combining node.

13. The method of claim 12, wherein the Doherty power amplifier circuit has an output loss of approximately 0.2 decibels.

14. The method of claim 12 or 13, wherein the second impedance and the third impedance combine to provide an effective impedance that has a zero-degree phase offset relative to the second amplified signal.

15. The method of any of claims 12 to 14, wherein the Doherty power amplifier circuit comprises a ninety-one hundred eighty, 90° -180°, Doherty amplifier.
